# EUROPEAN PATENT APPLICATION

(11) **EP 3 576 304 A1**
(43) Date of publication of application: **04.12.2019**
(21) Application number: 17899792.0
(22) Date of filing: 09.03.2017
(51) Int. Cl.: H03M 13/41

(54) **DECODING DEVICE**

(71) Applicant: Mitsubishi Electric Corporation, Chiyoda-ku Tokyo 100-8310 (JP)
(72) Inventor: NAKAMURA, Takahiko, Tokyo 100-8310 (JP)
(74) Representative: Pfenning, Meinig & Partner mbB
(86) International application number: PCT/JP2017/009552
(87) International publication number: WO 2018/163369

(57) **Abstract**

A decoding device (1) includes a decode processing unit (30) and a data temporary saving unit (11) holding, of reception data to be input to the decode processing unit, a first number of pieces of reception data from a beginning of a frame and outputting the reception data being held after completion of inputting of one frame of the reception data to the decode processing unit. The decode processing unit includes a branch metric calculation unit (13) calculating a branch metric, an ACS calculation unit (14) identifying a survivor path associated with each of states and calculating path metrics of the survivor paths based on the branch metric, a survivor path storage unit (16) storing and holding a value determined based on each survivor path in each corresponding one of shift registers associated with the states, and an output selection unit (18) outputting, among values output from the shift registers of the survivor path storage unit, a value associated with a path metric having the maximum likelihood among current path metrics, as a decoding result.

## Description

### Field

The present invention relates to a decoding device for decoding a tail-biting convolutional code.

### Background

A conventional decoding device for a tail-biting convolutional code is described in Patent Literature 1.
The decoding device described in Patent Literature 1 first processes a received frame to be decoded such that a sequence containing an end portion of a bit sequence to be decoded is added to the beginning of the bit sequence to be decoded, as a prefix, and a sequence containing a head portion of the bit sequence to be decoded is added to the end of the bit sequence to be decoded, as a postfix, to reconstruct the received frame. Next, the decoding device decodes the reconstructed received frame using a decoder for zero-tail convolutional codes, designed based on the same generator polynomial as that used for generating a tail-biting convolutional code. In this operation, the decoding device selects a path having a high likelihood using a Viterbi decoding algorithm, holds the selected path in a path memory, and traces back along the selected path after inputting of the entire data of the reconstructed received frame, to generate a decoding result.

In addition, another conventional decoding device for a tail-biting convolutional code is described in Non-Patent Literature 1. The decoding device described in Non-Patent Literature 1 adds a sequence containing a head portion of a bit sequence to be decoded, as a postfix, to reconstruct the received frame. Then, the decoding device sets the initial values of the path metric values of all states to the same value for the reconstructed received frame, and holds the result of selection of a path having a high likelihood using a Viterbi decoding algorithm, in a path memory. The decoding device traces back along the path having the highest path metric value after inputting of the entire data of the reconstructed received frame, to generate a decoding result.

### Citation List

### Patent Literature

Patent Literature 1: Japanese Patent No. 5315449

### Non-Patent Literature

Non-Patent Literature 1: "To bite or not to bite-a study of tail bits versus tail-biting", Personal, Indoor, and Mobile Radio Communications, 1996. PIMRC'96, Seventh IEEE International Symposium, Volume 2, Oct. 15-18, 1996, Page(s) : 317-321.

### Summary

### Technical Problem

The decoding device described in Patent Literature 1 and the decoding device described in Non-Patent Literature 1 each perform traceback processing after completion of inputting of the data of the reconstructed received frame to generate a decoding result. This poses a problem in that a decoding delay increases.

The present invention has been made in view of the foregoing, and it is an object of the present invention to provide a decoding device capable of reducing a decoding delay in decode processing on a tail-biting convolutional code.

### Solution to Problem

To solve the problem and achieve the object described above, a decoding device according to an aspect of the present invention includes: a decode processing unit to decode, on a basis of a Viterbi algorithm, tail-biting convolutionally encoded reception data; and a data hold unit to hold, of reception data to be input to the decode processing unit, a first number of pieces of the reception data from a beginning of a frame, and to output the reception data being held to the decode processing unit after completion of inputting of one frame of the reception data to the decode processing unit. The decode processing unit includes a branch metric calculation unit to calculate a branch metric of each of states based on the Viterbi algorithm each time the reception data is input, a survivor path identification unit to, on a basis of the branch metric, identify a survivor path associated with each of the states and calculate a path metric of the survivor path, a survivor path storage unit to store and hold a value determined based on each of the survivor paths identified by the survivor path identification unit, in a corresponding one of a plurality of shift registers respectively associated with the states, and an output selection unit to output, among values output from the plurality of shift registers of the survivor path storage unit, a value associated with a path metric having a maximum likelihood among current path metrics calculated by the survivor path identification unit, as a decoding result.

### Advantageous Effects of Invention

A decoding device according to the present invention provides an advantage in that a decoding delay in decode processing on a tail-biting convolutional code can be reduced.

### Brief Description of Drawings

FIG. 1 is a diagram illustrating an example configuration of a decoding device according to a first embodiment.
FIG. 2 is a diagram illustrating a relationship between input timing of reception data to the decoding device according to the first embodiment and output timing of a decoding result from the decoding device.
FIG. 3 is a diagram illustrating an example configuration of hardware in a case in which components of the decoding device according to the first embodiment are implemented in a dedicated hardware element.
FIG. 4 is a diagram illustrating an example configuration of hardware in a case in which components of the decoding device according to the first embodiment are implemented in a control circuit.
FIG. 5 is a diagram illustrating a relationship between input timing of reception data to the decoding device according to a second embodiment and output timing of a decoding result from the decoding device.
FIG. 6 is a diagram illustrating an example configuration of a decoding device according to a third embodiment.
FIG. 7 is a diagram illustrating relationships between input timing of reception data to the decoding device according to the third embodiment and output timing of a decoding result from the decoding device.
FIG. 8 is a diagram illustrating an example configuration of a decoding device according to a fourth embodiment.
FIG. 9 is a diagram illustrating relationships between input timing of reception data to the decoding device according to the fourth embodiment and output timing of a decoding result from the decoding device.

### Description of Embodiments

A decoding device according to embodiments of the present invention will be described in detail below with reference to the drawings. Note that these embodiments are not intended to limit the scope of this invention.

### First Embodiment.

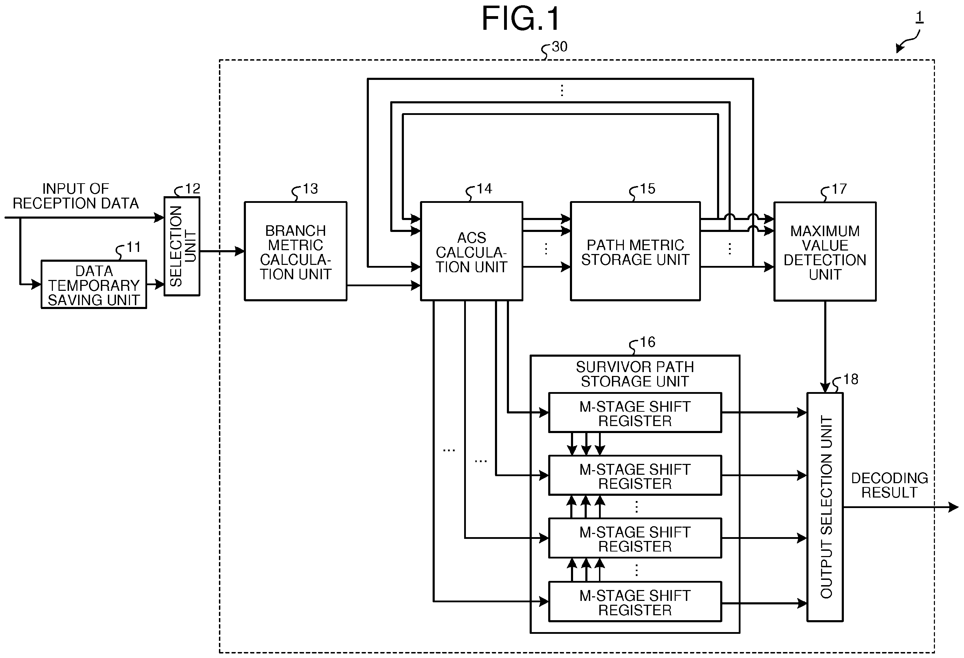

FIG. 1 is a diagram illustrating an example configuration of a decoding device according to a first embodiment of the present invention. A decoding device 1 according to the first embodiment includes a data temporary saving unit 11, a selection unit 12, a branch metric calculation unit 13, an add-compare-select (ACS) calculation unit 14, a path metric storage unit 15, a survivor path storage unit 16, a maximum value detection unit 17, and an output selection unit 18. The decoding device 1 decodes tail-biting convolutionally encoded data by Viterbi decode processing based on a Viterbi algorithm. The branch metric calculation unit 13, the ACS calculation unit 14, the path metric storage unit 15, the survivor path storage unit 16, the maximum value detection unit 17, and the output selection unit 18 together form a decode processing unit 30, which decodes tail-biting convolutionally encoded reception data that is externally input, on a frame-by-frame basis with respect to the reception data, on the basis of a Viterbi algorithm.

The data temporary saving unit 11, which is a data hold unit, performs temporary saving processing of holding, for a certain time period, a predetermined fixed number of pieces of reception data from the beginning of the frame, of the reception data externally input to the decoding device 1, and then outputting those pieces of reception data.

The selection unit 12 selects and outputs either the reception data externally input to the decoding device 1 or the reception data input from the data temporary saving unit 11.

The branch metric calculation unit 13 calculates a branch metric at each time instant on the basis of the reception data input from the selection unit 12. In the present embodiment, a higher level of similarity between a received signal and a replica signal will result in a higher branch metric value.

The ACS calculation unit 14, which is a survivor path identification unit, identifies a survivor path that is associated with each of the states on the basis of branch metrics, and also calculates a path metric of that survivor path. Specifically, the ACS calculation unit 14 calculates two candidates for an updated path metric for each of the states based on the Viterbi algorithm, using branch metrics and a path metric held in the path metric storage unit 15 described later, and selects the candidate having a higher likelihood from the two candidates calculated, as the updated path metric. In the present embodiment, the candidate having a higher likelihood means a candidate having a higher path metric value. The ACS calculation unit 14 outputs the updated path metric of each state to the path metric storage unit 15. The path associated with the updated path metric is the survivor path. In addition, the ACS calculation unit 14 notifies the survivor path storage unit 16 of the survivor path identified, i.e., the selection result of selecting the updated path metric.

The path metric storage unit 15 receives and holds the path metric of each state output from the ACS calculation unit 14. It is assumed here that the path metric storage unit 15 holds the same value as the initial values of the path metrics for the respective states before receiving the path metrics for the respective states from the ACS calculation unit 14 for the first time.

The survivor path storage unit 16 performs a process described later herein on the basis of the selection result indicated by the ACS calculation unit 14, and thus stores the survivor path of each state identified by the ACS calculation unit 14 and outputs candidates for the decoding result associated with each state.

The maximum value detection unit 17 detects the path metric having the maximum likelihood, i.e., the path metric having the maximum value, for each state held in the path metric storage unit 15.

The output selection unit 18 selects, from the candidates for the decoding result output from the survivor path storage unit 16, the candidate associated with the path metric detected by the maximum value detection unit 17, and outputs the selected candidate as the decoding result.

An overall operation of the decoding device 1 according to the first embodiment will next be described. The description below assumes that the convolutional encoder used in a device on the data transmission side uses a constraint length of K.

The decoding device 1 sequentially receives a reception sequence that is one frame of convolutionally-encoded reception data as reception data having a length corresponding to time instant N. Note that N represents a positive integer and is equivalent to the number of bits after decoding. The reception data having a length corresponding to time instant N is input to the selection unit 12. The reception data is also input to the data temporary saving unit 11. The data temporary saving unit 11 extracts M pieces of the reception data that is a data portion from the beginning to a portion corresponding to time instant M of the reception sequence input, and holds this data portion for a certain time period. Note that the present embodiment assumes that M represents a positive integer less than or equal to N. M represents a first number, and an operation of the decoding device 1 in a case when M has a value greater than N will be described in a second embodiment.

During reception of the reception sequence from the beginning to the time instant N portion, the selection unit 12 selects and outputs the reception data input, to the branch metric calculation unit 13. After reception of the entire reception data, i.e., after reception of the N pieces of reception data until time instant N, the selection unit 12 selects M pieces of the reception data held by the data temporary saving unit 11 sequentially from the beginning, and outputs the M pieces of the reception data to the branch metric calculation unit 13. This causes the branch metric calculation unit 13 to have one frame of reception data sequentially input from the beginning, and after completion of inputting of the one frame of reception data, have reception data input again, from the beginning to the M-th piece of the one frame of reception data that has been input.

The branch metric calculation unit 13 calculates a branch metric at each time instant each time the reception data is input from the selection unit 12. Note that the branch metric calculation unit 13 calculates a branch metric using a known method. The branch metric calculation unit 13 calculates a branch metric such that, for example, a higher level of similarity between a received signal and a replica signal results in a higher value. Two branch metrics are calculated for each of the 2^{K-1} states. The branch metric calculation unit 13 outputs the calculated branch metrics to the ACS calculation unit 14.

Each time a set of branch metrics is input from the branch metric calculation unit 13, the ACS calculation unit 14 calculates a current path metric on the basis of the set of branch metrics input and a path metric held in the path metric storage unit 15. For example, the ACS calculation unit 14 first adds each of the two branch metrics existing per state to the path metric of each state held in the path metric storage unit 15 to generate two candidates for the path metric of each state. The ACS calculation unit 14 then selects, for each state, the path metric having a smaller value from the two candidates as the current path metric. Note that the ACS calculation unit 14 may first select the branch metric having a smaller value from the two branch metrics of each state, and then add the selected branch metric to the path metric to determine the current path metric. The ACS calculation unit 14 outputs the current path metric of each state to the path metric storage unit 15. As a result, the path metric of each state held by the path metric storage unit 15 is updated to the current path metric. In addition, the ACS calculation unit 14 outputs the number of the state associated with the candidate selected as the current path metric, to the survivor path storage unit 16 as the selection result.

A specific example of operation of the ACS calculation unit 14 will now be described. The number of each of the 2^{K-1} states is denoted by A (=0, 1, 2, ..., 2^{K-1}-1), and the state having the number A is denoted by "state (A)". Then, to calculate the current path metric for state (A), the ACS calculation unit 14 first reads the path metric for state (A/2) from the path metric storage unit 15. As used herein, the expression "A/2" denotes the quotient of A divided by 2. For example, A=0 results in A/2=0 and A=5 results in A/2=2. The ACS calculation unit 14 then adds the branch metric of the branch that connects state (A/2) with state (A) to the path metric for state (A/2) read, and determines that the sum is a first candidate for the path metric for state (A). The ACS calculation unit 14 also adds the branch metric of the branch that connects state (A/2+2^{K-2}) with state (A) to the path metric for state (A), and determines that the sum is a second candidate for the path metric for state (A). The ACS calculation unit 14 then selects a candidate having a higher value from the first candidate and the second candidate for the path metric for state (A), as the current path metric for state (A). In this case, the ACS calculation unit 14 notifies the survivor path storage unit 16 of the number of the state associated with the current path metric, i.e., A/2 or A/2+2^{K-2}, as the selection result for state (A).

The survivor path storage unit 16 includes 2^{K-1} shift registers each having M stages (hereinafter, M-stage shift registers). The M-stage shift registers correspond to the respective states. The number of stages of each of the M-stage shift registers is equal to the length of the reception data held by the data temporary saving unit 11 for a certain time period. Upon notification of a selection result for each state, i.e., the number of state for that state, from the ACS calculation unit 14, the survivor path storage unit 16 performs the procedure described below to update the survivor path stored in the M-stage shift register corresponding to that state. In this operation, the survivor path storage unit 16 outputs the most significant bit, i.e., the bit stored in the M-th stage register, i.e., top register, among the bits stored in that M-stage shift register, to the output selection unit 18 as the candidate for the decoding result, the candidate corresponding to the survivor path of that state.

In the survivor path update process, the survivor path storage unit 16 first performs a process in relation to the M-stage shift register associated with state (A) of reading the value stored in the M-stage shift register associated with the selection result indicated by the ACS calculation unit 14, i.e., either the value stored in the M-stage shift register associated with state (A/2) or the value stored in the M-stage shift register associated with state (A/2+2^{K-2}), shifting the read value by one bit, and loading the shifted value to the M-stage shift register of state (A). Next, in a case in which the number A of the state is an even number, the survivor path storage unit 16 sets the least significant bit of the M-stage shift register associated with state (A) to '0', while in a case in which the number A of the state is an odd number, the survivor path storage unit 16 sets the least significant bit of the M-stage shift register associated with state (A) to '1'. Thus, the bit sequence stored in each of the M-stage shift registers depends on the survivor path of that state identified by the ACS calculation unit 14. A specific example of operation of updating the survivor path associated with each state performed by the survivor path storage unit 16 will be described below.

When "state 0" is indicated as the selection result for the current path metric of state 1, the survivor path storage unit 16 operates as follows. In this case, the survivor path storage unit 16 reads the value stored in the M-stage shift register associated with state 0, shifts the read value by one bit, adds '1' as the least significant bit, and loads the resultant value in the M-stage shift register associated with state 1. Alternatively, when "state 3" is indicated as the selection result for the current path metric of state 2, the survivor path storage unit 16 operates as follows. In this case, the survivor path storage unit 16 reads the value stored in the M-stage shift register associated with state 3, shifts the read value by one bit, adds '0' as the least significant bit, and loads the resultant value in the M-stage shift register associated with state 2.

The maximum value detection unit 17 detects a path metric having the maximum likelihood, i.e., a path metric having the minimum value, among the path metrics of 2^{K-1} states, and outputs the state number corresponding to the detected path metric to the output selection unit 18.

When the time instant of input reaches or exceeds M+1, that is, when reception data at (M+1)-th time instant or later from the beginning is input to the decoding device 1, the output selection unit 18 starts a process of outputting, as the decoding result, what has been output from the M-stage shift register corresponding to the state number that has been output from the maximum value detection unit 17, among the candidates for the decoding result that is to be output from the survivor path storage unit 16.

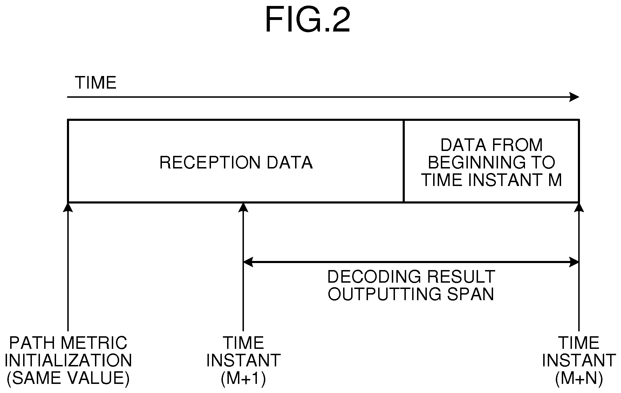

Iteratively performing of the processes described above by components of the decoding device 1 enables the decoding device 1 to output a decoding result at timing illustrated in FIG. 2 while receiving reception data. That is, the decoding device 1 outputs a decoding result for N-bit reception data in a time span from time instant M+1 to time instant M+N counting from the beginning of the reception data. Thus, the decoding device 1 can reduce the decoding delay and reduce the performance degradation. Note that FIG. 2 is a diagram illustrating a relationship between input timing of reception data to the decoding device 1 according to the first embodiment and output timing of the decoding result from the decoding device 1.

As described above, the decoding device 1 according to the present embodiment is configured such that the branch metric calculation unit 13 and the processing units downstream thereof perform decode processing on a predetermined length of portion of the reception data from the beginning of the reception data and the data temporary saving unit 11 temporarily holds the predetermined length of portion of the reception data. After reception of one frame of the reception data, the branch metric calculation unit 13 and the processing units downstream thereof perform decode processing sequentially from the beginning on the reception data temporarily held by the data temporary saving unit 11. This can reduce the decoding delay in decode processing on a tail-biting convolutional code. Note that, in the decoding device 1, the data temporary saving unit 11 temporarily holds reception data of the same length as the length of reception data that is input to the branch metric calculation unit 13 during a time period from the start of inputting of the reception data to the branch metric calculation unit 13 and to the processing units downstream thereof until the start of outputting of the decoding result. This can further reduce the decoding delay.

A hardware configuration of the decoding device 1 will now be described. The data temporary saving unit 11, the selection unit 12, the branch metric calculation unit 13, the ACS calculation unit 14, the path metric storage unit 15, the survivor path storage unit 16, the maximum value detection unit 17, and the output selection unit 18 that form the decoding device are implemented in a processing circuit. That is, the decoding device 1 includes a processing circuit for holding a beginning portion of reception data of a predetermined length in the data temporary saving unit 11 and also for inputting that portion of reception data to a circuit that performs Viterbi decode processing; for selecting and inputting the reception data held in the data temporary saving unit 11 to the circuit that performs Viterbi decode processing after completion of reception of the entire data to reconstruct the received frame; and for selecting and outputting, on a bit-by-bit basis, the decoding result of the state corresponding to the path metric having the maximum likelihood, from the candidates for the decoding result of all the states after performing of Viterbi decode processing each time a portion of the reception data corresponding to one time instant is input. The processing circuit may be a dedicated hardware element or a control circuit including a processor and a memory.

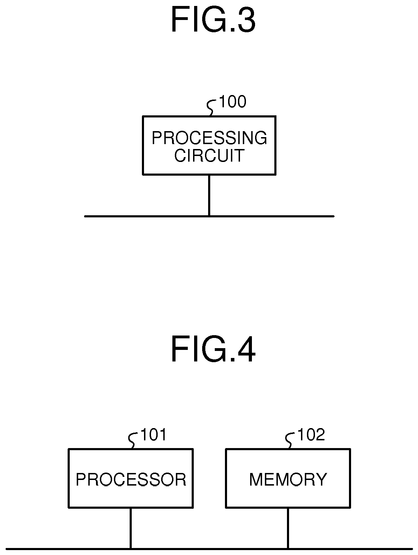

FIG. 3 is a diagram illustrating an example configuration of hardware in a case in which components of the decoding device 1 are implemented in a dedicated hardware element. In a case in which the data temporary saving unit 11, the selection unit 12, the branch metric calculation unit 13, the ACS calculation unit 14, the path metric storage unit 15, the survivor path storage unit 16, the maximum value detection unit 17, and the output selection unit 18 of the decoding device 1 are implemented in a dedicated hardware element, a processing circuit 100, which is the dedicated hardware element, is, for example, a single circuit, a composite circuit, a programmed processor, a parallel programmed processor, an application specific integrated circuit (ASIC), a field programmable gate array (FPGA), or a combination thereof. The data temporary saving unit 11, the selection unit 12, the branch metric calculation unit 13, the ACS calculation unit 14, the path metric storage unit 15, the survivor path storage unit 16, the maximum value detection unit 17, and the output selection unit 18 may each be implemented in a combination of multiple processing circuits, or otherwise, the functions of these components may together be implemented in a single processing circuit.

FIG. 4 is a diagram illustrating an example configuration of hardware in a case in which components of the decoding device 1 are implemented in a control circuit. In a case in which the decoding device 1 is implemented in a control circuit, the control circuit includes a processor 101 and a memory 102. The processor 101 is a central processing unit (CPU) (also referred to as central processing unit, processing device, computing unit, microprocessor, microcomputer, digital signal processor (DSP)), a system large scale integration (LSI), or the like. The memory 102 is typically a non-volatile or volatile semiconductor memory such as a random access memory (RAM), a read-only memory (ROM), a flash memory, an erasable programmable read-only memory (EPROM), or an electrically erasable programmable read-only memory (EEPROM), but may also be a magnetic disk, a flexible disk, an optical disk, a compact disc, a MiniDisc, a digital versatile disk (DVD), or the like.

In a case in which the data temporary saving unit 11, the selection unit 12, the branch metric calculation unit 13, the ACS calculation unit 14, the path metric storage unit 15, the survivor path storage unit 16, the maximum value detection unit 17, and the output selection unit 18 are implemented in a control circuit, the functions of these components are implemented in software, firmware, or a combination of software and firmware. The software and firmware are described as a program and is stored in the memory 102. The processor 101 reads and executes a program stored in the memory 102 to implement the functions of components of the decoding device 1. That is, the decoding device 1 includes the memory 102 for storing a program that upon execution by the control circuit, causes steps to be performed, where the steps include a step of temporarily saving a predetermined length of portion of reception data from the beginning, inputting this portion of reception data to the unit that performs Viterbi decode processing, and, after completion of inputting of the entire data, inputting the temporarily saved reception data to the unit that performs Viterbi decode processing, to reconstruct the received frame; and a step of selecting and outputting, on a bit-by-bit basis, the decoding result of the state corresponding to the path metric having the maximum likelihood, from the candidates for the decoding result of all the states after performing Viterbi decode processing each time a portion of the reception data corresponding to one time instant is input. It can also be said that this program causes a computer to perform procedures or methods of the data temporary saving unit 11, the selection unit 12, the branch metric calculation unit 13, the ACS calculation unit 14, the path metric storage unit 15, the survivor path storage unit 16, the maximum value detection unit 17, and the output selection unit 18.

Note that the data temporary saving unit 11, the selection unit 12, the branch metric calculation unit 13, the ACS calculation unit 14, the path metric storage unit 15, the survivor path storage unit 16, the maximum value detection unit 17, and the output selection unit 18 may be partially implemented in a dedicated hardware element, and partially implemented in software or firmware. For example, the decoding device 1 may be configured such that the functions of the branch metric calculation unit 13 and of the ACS calculation unit 14 are implemented in the processing circuit 100 serving as the dedicated hardware element and the functions of the other components are implemented by the processor 101 by reading and executing a program stored in the memory 102.

As described above, the functions of the decoding device 1 can be implemented by a processing circuit implemented in hardware, software, firmware, or a combination thereof.

### Second Embodiment.

The first embodiment has described decode processing in a case in which the data having a length corresponding to time instant M temporarily saved in the data temporary saving unit 11 is shorter in length than the reception data. In contrast, the second embodiment will describe decode processing in a case in which the data having a length corresponding to time instant M temporarily saved in the data temporary saving unit 11 is longer in length than the reception data. Note that the decoding device according to the second embodiment is configured identically to the decoding device 1 according to the first embodiment. The decoding device according to the second embodiment differs from the decoding device 1 according to the first embodiment in the operations of the data temporary saving unit 11 and of the selection unit 12.

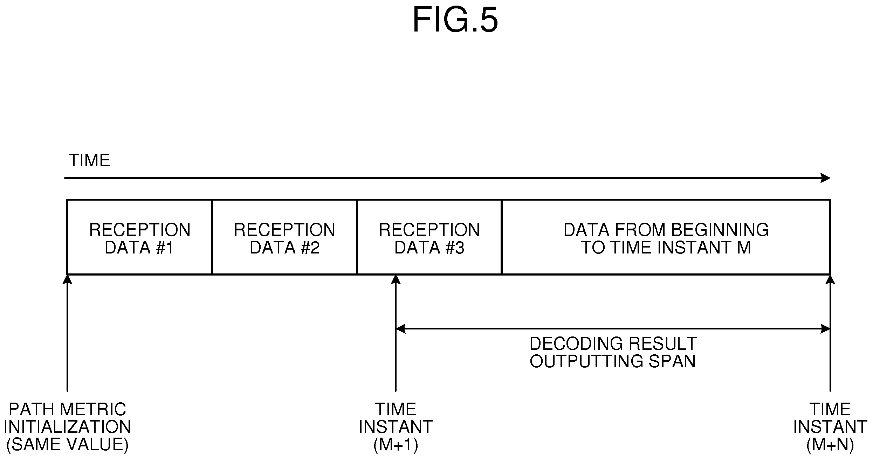

FIG. 5 is a diagram illustrating a relationship between input timing of reception data to the decoding device according to the second embodiment and output timing of the decoding result from the decoding device. In the case of the example illustrated in FIG. 5, the data temporary saving unit 11 holds the entire portion of each of reception data #1 and reception data #2 and a portion of reception data #3 from the beginning to a certain midway point.

An operation of the decoding device according to the second embodiment will next be described. The description below will describe differences from the operation of the decoding device 1 according to the first embodiment with reference to FIG. 5. In the decoding device according to the second embodiment, the data temporary saving unit 11 holds, upon reception of reception data, a sequence from the first to M-th portions of the reception data. In the case of the example illustrated in FIG. 5, the data temporary saving unit 11 holds the entire sequence of each of reception data #1 and reception data #2 and a sequence from the beginning to a certain midway point of reception data #3. The selection unit 12 inputs the entire sequence of each of reception data #1, #2, and #3 to the branch metric calculation unit 13, and then inputs the sequences held by the data temporary saving unit 11 to the branch metric calculation unit 13. The branch metric calculation unit 13, the ACS calculation unit 14, the path metric storage unit 15, the survivor path storage unit 16, the maximum value detection unit 17, and the output selection unit 18 operate similarly to those of the first embodiment.

As described above, in the decoding device 1 according to the present embodiment, the data temporary saving unit 11 holds the reception data in multiple frames in a case in which the amount of the reception data per frame is low. When the number of pieces of reception data held by the data temporary saving unit 11 reaches a required value, the selection unit 12 outputs the reception data held by the data temporary saving unit 11 to the branch metric calculation unit 13 before starting of outputting of the next frame to the branch metric calculation unit 13. This operation can provide an advantage similar to the advantage of the first embodiment also in a case of a short frame length.

### Third Embodiment.

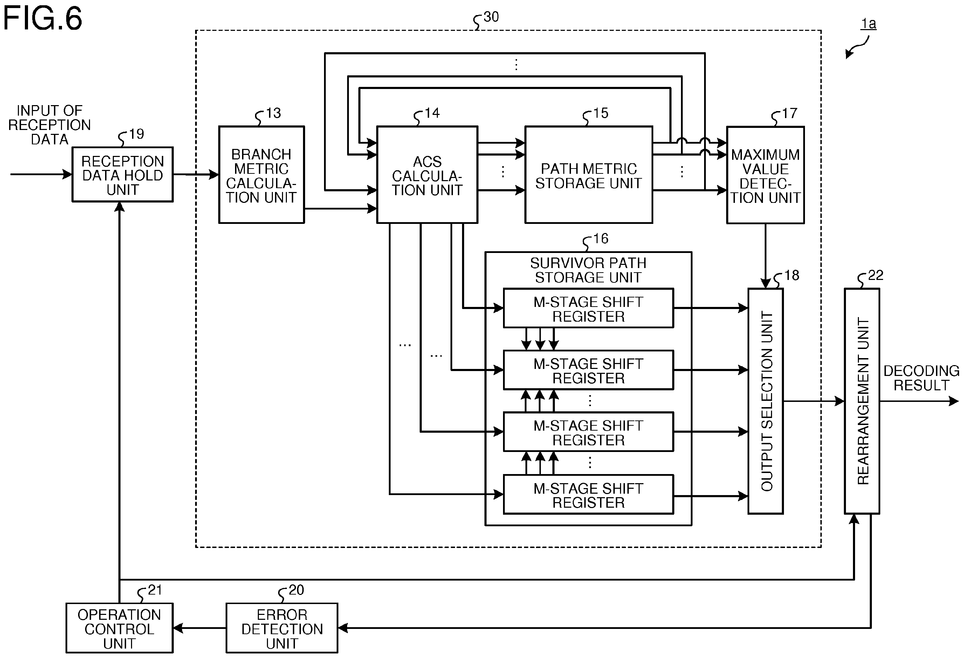

FIG. 6 is a diagram illustrating an example configuration of a decoding device according to a third embodiment. A decoding device 1a according to the third embodiment includes the branch metric calculation unit 13, the ACS calculation unit 14, the path metric storage unit 15, the survivor path storage unit 16, the maximum value detection unit 17, the output selection unit 18, a reception data hold unit 19, an error detection unit 20, an operation control unit 21, and a rearrangement unit 22.
The branch metric calculation unit 13, the ACS calculation unit 14, the path metric storage unit 15, the survivor path storage unit 16, the maximum value detection unit 17, and the output selection unit 18 are identical to the respective components, indicated by the same reference characters, of the decoding device 1 described in the first embodiment. Therefore, a description of these components will be omitted.

The reception data hold unit 19 tentatively holds reception data, and outputs the data being held on the basis of an instruction from the operation control unit 21. The error detection unit 20 determines whether the decoding result includes an error. The error detection unit 20 detects an error in the decoding result using, for example, a cyclic redundancy check (CRC). The operation control unit 21 controls the operations of the reception data hold unit 19 and of the rearrangement unit 22 on the basis of the error detection result of the error detection unit 20. The rearrangement unit 22 outputs the decoding result output from the output selection unit 18 as the ultimate decoding result without change if no instruction is received from the operation control unit 21 to perform rearrangement, and otherwise, if an instruction is received from the operation control unit 21 to perform rearrangement, the rearrangement unit 22 rearranges the decoding result output from the output selection unit 18 on the basis of the instruction, and outputs the rearranged decoding result as the ultimate decoding result.

An operation of the decoding device 1a according to the third embodiment will next be described. Note that the description below will describe differences from the operation of the decoding device 1 according to the first embodiment. Similarly to the first embodiment, the number of bits after decoding is assumed to be N.

The decoding device 1a sequentially receives one frame of reception data, and the reception data received is tentatively held in the reception data hold unit 19. At the instant of start of decoding of the reception data, the operation control unit 21 instructs the reception data hold unit 19 to output the reception data sequentially from the reception data portion at the beginning to the last reception data portion, i.e., the reception data portion at time instant N, and then again output the reception data sequentially from the beginning to a time instant M portion. Upon reception of this instruction, the reception data hold unit 19 sequentially outputs the reception sequence from the beginning to the end, and further outputs the reception sequence from the beginning to the time instant M portion. The branch metric calculation unit 13, the ACS calculation unit 14, the path metric storage unit 15, the survivor path storage unit 16, the maximum value detection unit 17, and the output selection unit 18 perform similar processing to the processing of the first embodiment to decode the reception sequence. The output selection unit 18 starts outputting of the decoding result at the time when the reception data portion at time instant M+1 is input to the branch metric calculation unit 13, and outputs the decoding result for the reception sequence sequentially from the beginning to the time instant N portion. The rearrangement unit 22 outputs the decoding result output from the output selection unit 18 to the error detection unit 20, and also tentatively holds the decoding result.

The error detection unit 20 performs error detection processing on the decoding result for one frame output from the rearrangement unit 22, and outputs a detection result, i.e., information indicating whether an error has been detected or not, to the operation control unit 21.

If no error has been detected by the error detection unit 20, the operation control unit 21 instructs the rearrangement unit 22 to output the decoding result being held. Upon reception of this instruction, the rearrangement unit 22 outputs the decoding result for one frame that has been tentatively held to the outside as the ultimate decoding result. In this case, the operation control unit 21 instructs the reception data hold unit 19 to discard the one frame of reception data corresponding to the decoding result output to the outside. Upon reception of this instruction, the reception data hold unit 19 discards the one frame of reception data.

Otherwise, if an error has been detected by the error detection unit 20, the operation control unit 21 instructs the reception data hold unit 19 to sequentially output a reception sequence from the beginning to a time instant P portion, and a subsequent reception data from a time instant P+1 portion to the time instant N portion, and thereafter sequentially output reception data from the beginning to a time instant P+M portion, where P represents a positive integer and satisfies P+M≤N. P represents a second number. Upon reception of this instruction, the reception data hold unit 19 outputs a data portion from the time instant P portion to the time instant N portion of the reception sequence, as reception data whose reception data portion at time instant P will be output first, and further outputs a reception sequence from the beginning to the time instant P+M portion. This causes the branch metric calculation unit 13 to receive a reception sequence having the reception data portion at time instant P being positioned at the beginning, which results from P-bit rotade shifting performed on one frame of N pieces of the reception data. In this case, the operation control unit 21 instructs the rearrangement unit 22 to discard the decoding result for one frame that has been tentatively held and to rearrange a decoding result that will be newly output from the output selection unit 18. Specifically, the operation control unit 21 instructs the rearrangement unit 22 to rearrange the decoding result newly output from the output selection unit 18 such that a first portion of the decoding result will be a P-th portion of the decoding result and a last portion of the decoding result will be a (P-1)-th portion of the decoding result. Upon reception of this instruction, the rearrangement unit 22 discards the decoding result for one frame that has been tentatively held, and then rearranges the decoding result for one frame newly output from the output selection unit 18 on the basis of the instruction, outputs the rearranged decoding result to the error detection unit 20, and also tentatively holds the rearranged decoding result.

Then, components of the decoding device 1a repeat the processing described above; specifically, repeat a process of outputting the decoding result held by the rearrangement unit 22 as the ultimate decoding result if the decoding result has no error therein, and changing the value of P described above, i.e., which portion of the reception data is to be first output by the reception data hold unit 19, and performing decode processing again if the decoding result includes an error. Note that the process is repeated not more than a predetermined fixed number of times. In a case in which a decoding result obtained after repeating of the above process the fixed number of times still includes an error, the rearrangement unit 22 outputs, to the outside, the decoding result being held and information indicating that the decoding result output includes an error.

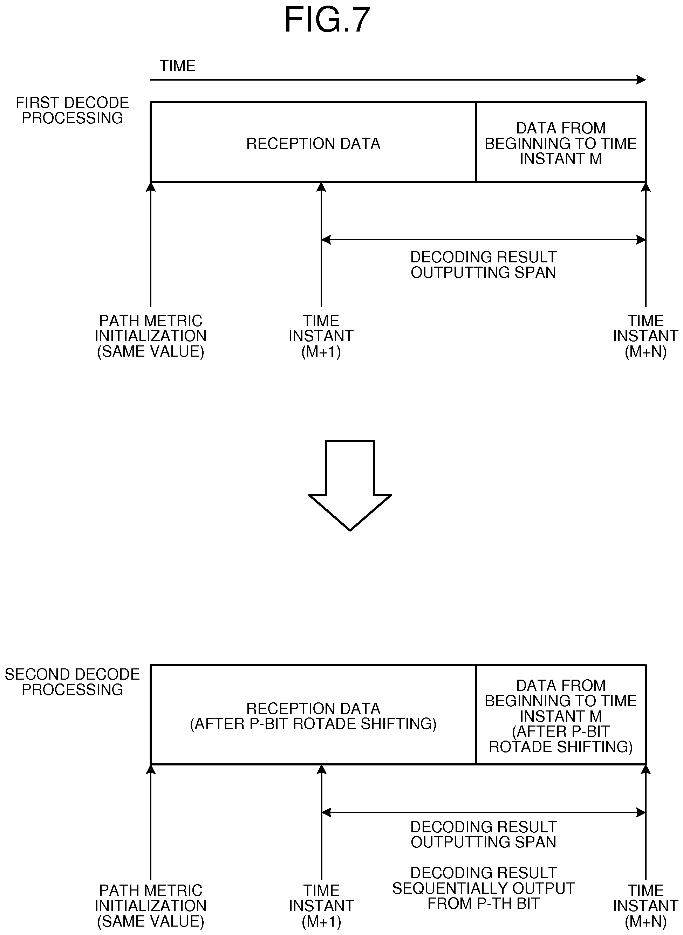

Iteratively performing of the processes described above by components of the decoding device 1a enables the decoding device 1a to output a decoding result at timing illustrated in FIG. 7. That is, the decoding device 1a outputs a decoding result for N-bit reception data in a time span from time instant M+1 to time instant M+N counting from the beginning of the reception data input to the branch metric calculation unit 13 in each decode processing iteratively performed. Note that FIG. 7 is a diagram illustrating relationships between input timing of reception data to the decoding device 1a according to the third embodiment and output timing of the decoding result from the decoding device 1a.

As described above, the decoding device 1a according to the present embodiment includes the reception data hold unit 19, which holds reception data; the error detection unit 20, which detects an error in a decoding result; the rearrangement unit 22 capable of rearranging the decoding result and of outputting the rearranged decoding result; and the operation control unit 21, which controls the order in which the reception data hold unit 19 outputs the reception sequence and the order in which the rearrangement unit 22 outputs the decoding result on the basis of the error detection result. The branch metric calculation unit 13 and the processing units downstream thereof iteratively decode the reception data held in the reception data hold unit 19 until no more errors are detected or until a fixed number of iterations is reached. This can provide a similar advantage to the advantage of the first embodiment and can provide improved decoding performance. This can also provide iterative decoding with a simple configuration.

The decoding device 1a according to the present embodiment can be implemented, similarly to the decoding device 1 according to the first embodiment, in hardware having a configuration illustrated in FIG. 3 or FIG. 4.

### Fourth Embodiment.

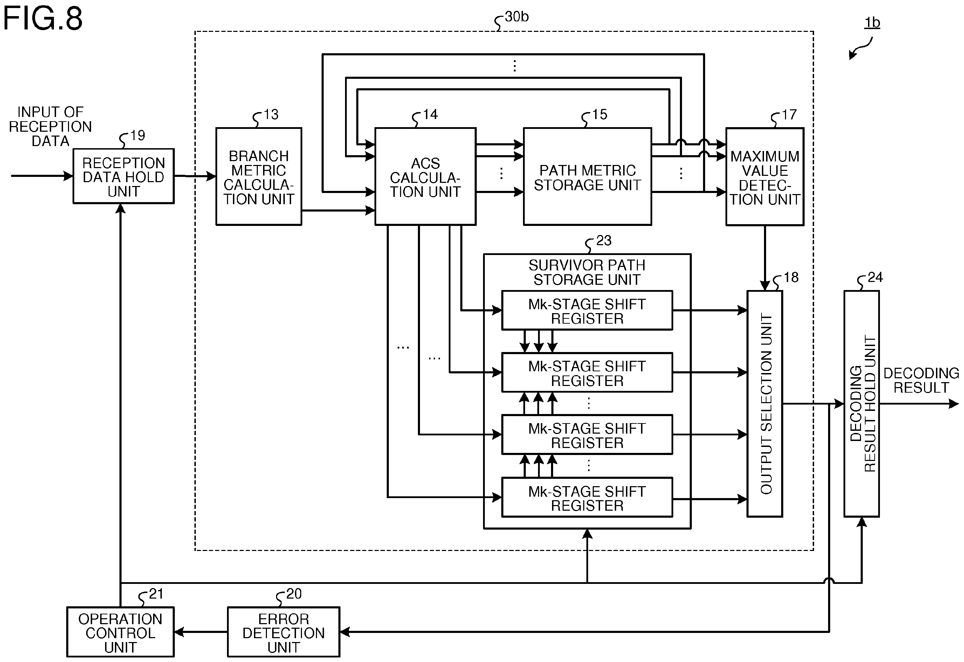

FIG. 8 is a diagram illustrating an example configuration of a decoding device according to a fourth embodiment. A decoding device 1b according to the fourth embodiment includes the branch metric calculation unit 13, the ACS calculation unit 14, the path metric storage unit 15, the maximum value detection unit 17, the output selection unit 18, the reception data hold unit 19, the error detection unit 20, an operation control unit 21b, a survivor path storage unit 23, and a decoding result hold unit 24. The branch metric calculation unit 13, the ACS calculation unit 14, the path metric storage unit 15, the survivor path storage unit 23, the maximum value detection unit 17, and the output selection unit 18 together form a decode processing unit 30b. The branch metric calculation unit 13, the ACS calculation unit 14, the path metric storage unit 15, the maximum value detection unit 17, the output selection unit 18, the reception data hold unit 19, and the error detection unit 20 are identical to the respective components, indicated by the same reference characters, of the decoding device 1a described in the third embodiment. Therefore, a description of these components will be omitted.

The operation control unit 21b controls the operations of the reception data hold unit 19, of the survivor path storage unit 23, and of the decoding result hold unit 24 on the basis of the error detection result of the error detection unit 20. The survivor path storage unit 23 differs from the survivor path storage unit 16 described in the first embodiment in that the multiple M-stage shift registers that constitute the survivor path storage unit 16 are each replaced by a shift register having Mk stages (hereinafter, Mk-stage shift register), where k is the maximum value of the number of iterations of decode processing performed by the decoding device 1b in a case in which an error has been detected in the decoding result. The survivor path storage unit 23 outputs the bit stored in the register at the position specified by the operation control unit 21b to the output selection unit 18 as a decoding result. Upon reception of a selection result of a branch from the ACS calculation unit 14, the survivor path storage unit 23 operates similarly to the survivor path storage unit 16 except that the survivor path storage unit 23 outputs the bit stored in the register at the position specified by the operation control unit 21b to the output selection unit 18 as a decoding result. The decoding result hold unit 24 receives the decoding result output from the output selection unit 18 and holds the decoding result until reception of an output instruction from the operation control unit 21b.

An operation of the decoding device 1b according to the fourth embodiment will next be described. The description below will describe differences from the operation of the decoding device 1a according to the third embodiment. Similarly to the third embodiment, the number of bits after decoding is assumed to be N.

The decoding device 1b sequentially receives one frame of reception data, and the reception data received is tentatively held in the reception data hold unit 19. At the instant of start of decoding of the reception data, the operation control unit 21b instructs the reception data hold unit 19 to output the reception data sequentially from the reception data portion at the beginning to the last reception data portion, i.e., the reception data portion at time instant N, and then again output the reception data sequentially from the beginning to a time instant M1 portion. Upon reception of this instruction, the reception data hold unit 19 sequentially outputs the reception sequence from the beginning to the end, and further outputs the reception sequence from the beginning to the time instant M1 portion. In parallel with this, the operation control unit 21b instructs the survivor path storage unit 23 to output the bit stored in the M1-th stage register of the Mk-stage shift register, as the decoding result for the corresponding state. The branch metric calculation unit 13, the ACS calculation unit 14, the path metric storage unit 15, the survivor path storage unit 23, the maximum value detection unit 17, and the output selection unit 18 perform similar processing to the processing of the first embodiment to decode the reception sequence. However, the survivor path storage unit 23 outputs the bit stored in the M1-th stage register of each of the Mk-stage shift registers when outputting the decoding result to the output selection unit 18. Note that the decoding result output by the output selection unit 18 is input to the decoding result hold unit 24 and to the error detection unit 20.
The decoding result hold unit 24 tentatively holds the decoding result output from the output selection unit 18.

If no error has been detected by the error detection unit 20, the operation control unit 21b instructs the decoding result hold unit 24 to output the decoding result being held. Upon reception of this instruction, the decoding result hold unit 24 outputs a decoding result for one frame that has been tentatively held to the outside as the ultimate decoding result. In this case, the operation control unit 21b instructs the reception data hold unit 19 to discard the one frame of the reception data corresponding to the decoding result output to the outside. Upon reception of this instruction, the reception data hold unit 19 discards the one frame of the reception data.

Otherwise, if an error has been detected by the error detection unit 20, the operation control unit 21b instructs the reception data hold unit 19 to output the reception data sequentially from the reception data portion at the beginning to the last reception data portion, i.e., the reception data portion at time instant N, and then again output the reception data sequentially from the beginning to a time instant M2 portion. Upon reception of this instruction, the reception data hold unit 19 sequentially outputs the reception sequence from the beginning to the end, and further outputs the reception sequence from the beginning to the time instant M2 portion. In parallel with this, the operation control unit 21b instructs the survivor path storage unit 23 to output the bit stored in the M2-th stage register of the Mk-stage shift register, as the decoding result for the corresponding state. The branch metric calculation unit 13, the ACS calculation unit 14, the path metric storage unit 15, the survivor path storage unit 23, the maximum value detection unit 17, and the output selection unit 18 perform similar processing to the processing of the first embodiment to decode the reception sequence. However, the survivor path storage unit 23 outputs the bit stored in the M2-th stage register of each of the Mk-stage shift registers when outputting the decoding result to the output selection unit 18. In addition, the operation control unit 21b instructs the decoding result hold unit 24 to discard the decoding result for one frame that has been tentatively held. Upon reception of this instruction, the decoding result hold unit 24 discards the decoding result for one frame that has been tentatively held.

Then, components of the operation control unit 21b repeat the processing described above; specifically, repeat a process of outputting the decoding result held by the decoding result hold unit 24 as the ultimate decoding result if the decoding result has no error therein, and changing the number of pieces of reception data output by the reception data hold unit 19, and performing decode processing again if the decoding result includes an error. Note that the process is repeated not more than a predetermined fixed number of times of k. That is, the iterative decoding is terminated when the survivor path storage unit 23 outputs the bit stored in the Mk-th stage register of each of the Mk-stage shift registers. In a case in which a decoding result obtained after repeating of the above process the fixed number of times still includes an error, the decoding result hold unit 24 outputs, to the outside, the decoding result being held and information indicating that the decoding result output includes an error. Note that the value of M1, M2, ..., or Mk is a third number.

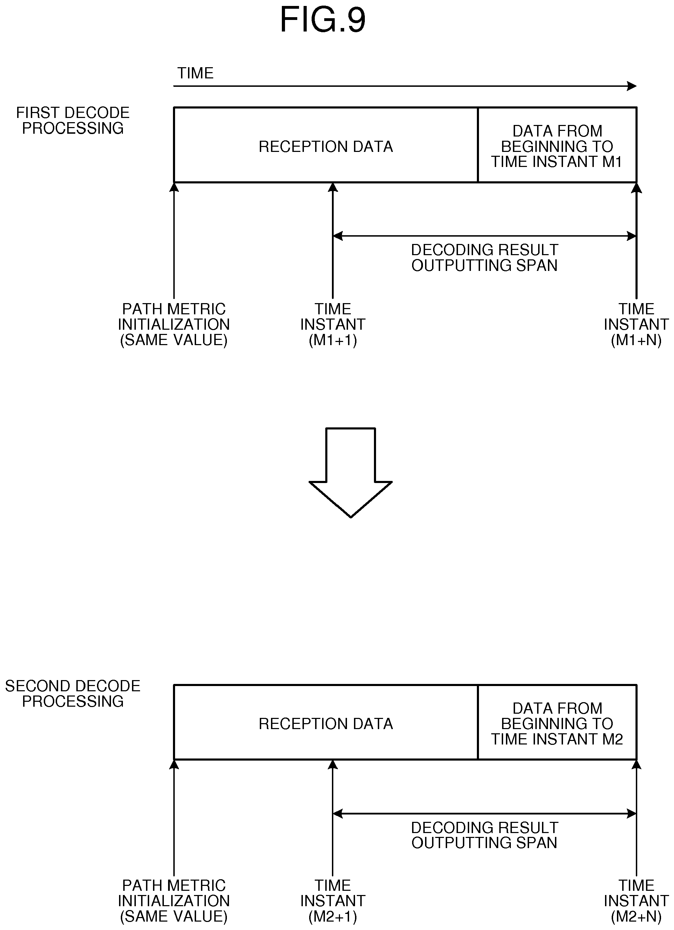

Performing of the processes described above by components of the decoding device 1b causes the decoding device 1b to output a decoding result at timing illustrated in FIG. 9. Note that FIG. 9 is a diagram illustrating relationships between input timing of reception data to the decoding device 1b according to the fourth embodiment and output timing of the decoding result from the decoding device 1b.

As described above, the decoding device 1b according to the present embodiment includes the survivor path storage unit 23 constituted by Mk-stage shift registers; the reception data hold unit 19, which holds reception data; the error detection unit 20, which detects an error in a decoding result; the decoding result hold unit 24, which holds the decoding result; and the operation control unit 21b, which controls the reception data hold unit 19, the survivor path storage unit 23, and the decoding result hold unit 24 on the basis of the error detection result. The decoding device 1b iteratively decodes the reception data while changing the length of the reception data input to the branch metric calculation unit 13 until no more errors are detected or until a fixed number of iterations is reached. This can provide a similar advantage to the advantage of the third embodiment.

The decoding device 1b according to the present embodiment can be implemented, similarly to the decoding device 1 according to the first embodiment, in hardware having a configuration illustrated in FIG. 3 or FIG. 4.

The configurations described in the foregoing embodiments are merely examples of various aspects of the present invention. These configurations may be combined with a known other technology, and moreover, a part of such configurations may be omitted and/or modified without departing from the spirit of the present invention.

### Reference Signs List

1, 1a, 1b decoding device; 11 data temporary saving unit; 12 selection unit; 13 branch metric calculation unit; 14 ACS calculation unit; 15 path metric storage unit; 16, 23 survivor path storage unit; 17 maximum value detection unit; 18 output selection unit; 19 reception data hold unit; 20 error detection unit; 21, 21b operation control unit; 22 rearrangement unit; 24 decoding result hold unit; 30, 30b decode processing unit.

## Claims

1. A decoding device comprising:
a decode processing unit to decode, on a basis of a Viterbi algorithm, tail-biting convolutionally encoded reception data; and
a data hold unit to hold, of reception data to be input to the decode processing unit, a first number of pieces of the reception data from a beginning of a frame, and to output the reception data being held to the decode processing unit after completion of inputting of one frame of the reception data to the decode processing unit, wherein
the decode processing unit includes
a branch metric calculation unit to calculate a branch metric of each of states based on the Viterbi algorithm each time the reception data is input,
a survivor path identification unit to, on a basis of the branch metric, identify a survivor path associated with each of the states and calculate a path metric of the survivor path,
a survivor path storage unit to store and hold a value determined based on each of the survivor paths identified by the survivor path identification unit, in a corresponding one of a plurality of shift registers respectively associated with the states, and
an output selection unit to output, among values output from the plurality of shift registers of the survivor path storage unit, a value associated with a path metric having a maximum likelihood among current path metrics calculated by the survivor path identification unit, as a decoding result.

2. The decoding device according to claim 1, wherein in a case in which the first number is greater than a number of pieces of the reception data contained in one frame, the data hold unit holds the reception data in a plurality of frames, and when the number of pieces of the reception data being held reaches the first number, the data hold unit waits for completion of inputting of the one frame of the reception data to the decode processing unit, and after completion of inputting of the one frame of the reception data to the decode processing unit, the data hold unit outputs the reception data being held.

3. The decoding device according to claim 1, comprising:
an error detection unit to detect an error in the decoding result to be output from the decode processing unit;
a rearrangement unit capable of rearranging the decoding result to be output from the decode processing unit and then outputting a resultant decoding result; and
an operation control unit to control the data hold unit and the rearrangement unit on a basis of an error detection result of the error detection unit, wherein
the data hold unit receives the reception data to be input to the decode processing unit, outputs the received reception data to the decode processing unit and also holds the received reception data, and upon completion of outputting of one frame of the reception data to the decode processing unit, selects a second number of pieces of the reception data from the reception data being held, and outputs the selected reception data to the decode processing unit, and
in a case in which no error is detected by the error detection unit, the operation control unit instructs the rearrangement unit to output the decoding result without rearrangement, and in a case in which an error is detected by the error detection unit, the operation control unit instructs the data hold unit to change a position of the reception data to be first output to the decode processing unit and again output the one frame of the data and the second number of pieces of the reception data, and also instructs the rearrangement unit to rearrange the decoding result in an order as instructed to the data hold unit and then output the rearranged decoding result.

4. The decoding device according to claim 1, comprising:
an error detection unit to detect an error in the decoding result to be output from the decode processing unit;
a decoding result hold unit to hold the decoding result to be output from the decode processing unit; and
an operation control unit to control the data hold unit, the survivor path storage unit, and the decoding result hold unit on a basis of an error detection result of the error detection unit, wherein
the data hold unit receives the reception data to be input to the decode processing unit, outputs the received reception data to the decode processing unit and also holds the received reception data, and upon completion of outputting of one frame of the reception data to the decode processing unit, selects a third number of pieces of the reception data from the reception data being held, and outputs the selected reception data to the decode processing unit,
the survivor path storage unit is configured such that a source register that outputs a value to the output selection unit is capable of being changed,
in a case in which no error is detected by the error detection unit, the operation control unit instructs the decoding result hold unit to output the decoding result being held, and
in a case in which an error is detected by the error detection unit, the operation control unit instructs the data hold unit to change a value of the third number and then again output the one frame of the reception data and the third number of pieces of the reception data, instructs the survivor path storage unit to select a register corresponding to an instruction given to the data hold unit as the source register, and instructs the decoding result hold unit to discard the decoding result being held.
